# EUROPEAN PATENT APPLICATION

(11) **EP 4 708 366 A1**
(43) Date of publication of application: **11.03.2026**
(21) Application number: 24824979.9
(22) Date of filing: 10.04.2024
(51) Int. Cl.: H01L 31/0236, H01L 31/06

(54) **COLOR SOLAR CELL, COLOR CELL MODULE, AND PHOTOVOLTAIC SYSTEM**

(30) Priority: 20.06.2023 CN 202310739918; 20.06.2023 CN 202321588266 U
(71) Applicant: Zhejiang Aiko Solar Energy Technology Co., Ltd., Yiwu, Jinhua Zhejiang 322000 (CN); Zhuhai Fushan Aiko Solar Energy Technology Co., Ltd., FushanIndustrial Park, Doumen District Zhuhai Guangdong 519000 (CN); Tianjin Aiko Solar Energy Technology Co., Ltd., Tianjin 300400 (CN); Guangdong Aiko Solar Energy Technology Co., Ltd., Foshan, Guangdong 528000 (CN)
(72) Inventor: LIN, Wenjie, Jinhua, Zhejiang 322000 (CN); QIU, Kaifu, Jinhua, Zhejiang 322000 (CN); WANG, Yongqian, Jinhua, Zhejiang 322000 (CN); ZHAO, Wei, Jinhua, Zhejiang 322000 (CN); LIU, Yibo, Jinhua, Zhejiang 322000 (CN); CHEN, Gang, Jinhua, Zhejiang 322000 (CN)
(74) Representative: EP&C
(86) International application number: PCT/CN2024/087024
(87) International publication number: WO 2024/260077

(57) **Abstract**

The present disclosure is applicable to the technical field of solar cells, and provides a colored solar cell (100), a colored solar module (200) and a photovoltaic system (1000). A polished surface of a silicon wafer (10) includes at least one of a front surface (11) and a back surface (12) of the silicon wafer (10), and several grooves (13) are formed in a partial region of the polished surface; the several grooves (13) are formed on the partial region of the polished surface so as to divide the polished surface into polished regions (111) and grooved regions (112), and the grooves (13) correspond to the grooved regions (112); and at least one pyramid structure (20) is formed in each groove (13), and an angle (α) between a side wall (21) of the pyramid structure (20) and a bottom edge (22) of the pyramid structure (20) is 0°-65°.

## Description

### Cross-Reference to Related Application

The present disclosure claims priority to and the benefit of Chinese Patent Application No. 202310739918.7 and No. 202321588266.3, filed to the China National Intellectual Property Administration on June 20, 2023, the disclosure of which is incorporated herein by reference in their entirety.

### Technical Field

The present disclosure relates to the field of solar cell technologies, and in particular, to a colored solar cell, a colored solar module, and a photovoltaic system.

### Background

In the related art, in order to enhance color vividness of a colored solar cell, it is common to configure the surface of a silicon wafer as a polished surface and subsequently depose a dielectric film layer on the polished surface to achieve coloration of the solar cell and improve the color vividness. However, in such cases, although the color brightness is relatively high, the reflectivity of the polished surface is also high, which may result in reduced power output of the solar cell and module. Additionally, due to variations in crystal orientation on the polished surface, the solar cell may suffer from issues of non-uniform brightness.

### Summary

The present disclosure provides a colored solar cell, a colored solar module and a photovoltaic system.

The present disclosure is implemented as follows: the colored solar cell of the embodiments of the present disclosure includes a silicon wafer having a polished surface, which includes at least one of a front surface and a back surface of the silicon wafer, where several grooves are formed in a partial region of the polished surface so as to divide the polished surface into polished regions and grooved regions, the grooves corresponds to the grooved regions, at least one pyramid structure is formed in each groove, and an angle between a side wall of the pyramid structure and a bottom edge of the pyramid structure is 0°-65°.

Still further, an angle between the side wall of the pyramid structure and the bottom edge of the pyramid structure is 45°-60°.

Still further, a depth of the groove is larger than or equal to a height of the pyramid structure.

Still further, a depth of the groove is 0.2 um-10 um.

Still further, a width of the groove is 0.2 um-10 um.

Still further, a ratio of an area of the polished regions to an area of the polished surface is 15%-85%.

Still further, a ratio of an area of the grooved regions to an area of the polished surface is 15%-85%.

Still further, an area of the grooved region is smaller than an area of the polished region.

Still further, a width of the groove is greater than or equal to a size of the bottom edge of the pyramid structure.

Still further, a size of the bottom edge of the pyramid structure is 0.2 um-10 um.

Still further, the several grooves are distributed randomly or in an array.

Still further, a plurality of pyramid structures are correspondingly arranged in a single groove, and the plurality of pyramid structures are independent of each other or at least some of the plurality of pyramid structures overlap with each other.

Still further, the pyramid structure has a sharp tip at a top; or
the pyramid structure has an arc-shaped top, and an angle between a side wall of the pyramid structure and a bottom edge of the pyramid structure is an angle between a connection line between an apex of the top of the pyramid structure and an endpoint of the bottom edge of the pyramid structure and the bottom edge of the pyramid structure.

The present disclosure further provides a colored solar module including the colored solar cell according to any one of the above content.

The present disclosure further provides a photovoltaic system, including the colored solar module according to any one of the above content.

In the colored solar cell, the colored solar module and the photovoltaic system of the embodiments of the present disclosure, the silicon wafer has a polished surface which includes at least one of a front surface and a back surface of the silicon wafer, and several grooves are formed in a partial region of the polished surface so as to divide the polished surface into polished regions and grooved regions, the grooves correspond to the grooved regions, at least one pyramid structure is formed in each groove, and an angle between a side wall of the pyramid structure and a bottom edge of the pyramid structure is 0°-65°.

Additional aspects and advantages of the present disclosure will be given in part in the following descriptions, become apparent in part from the following descriptions, or be learned from the practice of the present disclosure.

### Brief Description of the Drawings

Fig. 1 is a schematic module diagram of a photovoltaic system provided according to embodiments of the present disclosure;
Fig. 2 is a schematic module diagram of a colored solar module provided according to embodiments of the present disclosure;
Fig. 3 is a schematic structural diagram of a colored solar cell provided according to embodiments of the present disclosure;
Fig. 4 is another schematic structural diagram of a colored solar cell provided according to embodiments of the present disclosure;
Fig. 5 is a further schematic structural diagram of a colored solar cell provided according to embodiments of the present disclosure;
Fig. 6 is a still another schematic structural diagram of a colored solar cell provided according to embodiments of the present disclosure; and
Fig. 7 is a yet another schematic structural diagram of a colored solar cell provided according to embodiments of the present disclosure.

Reference signs for main elements:
photovoltaic system 1000, colored solar module 200, colored solar cell 100, silicon wafer 10, front surface 11, back surface 12, polished region 111, grooved region 113, groove 13, pyramid structure 20, dielectric film layer 30.

### Detailed Description of the Embodiments

To make the objectives, technical solutions, and advantages of the present disclosure clearer, hereinafter, the present disclosure is further described in detail in conjunction with the accompanying drawings and embodiments. Examples of the embodiments are shown in the accompanying drawings, and the same or similar reference numerals represent same or similar elements or elements having same or similar functions. The embodiments described below with reference to the accompanying drawings are exemplary and are only used to explain the present disclosure, and should not be construed as limiting the present disclosure. Furthermore, it should be understood that the specific embodiments described herein are only used to explain the present disclosure, and are not intended to limit the present disclosure.

In the illustration of the present disclosure, it should be understood that orientation or positional relationships indicated by the terms such as "front", "back", and "top" are orientation or positional relationships based on those as shown in the accompanying drawings, are only used to facilitate the illustration of the present disclosure and to simplify the illustration, rather than indicating or implying that a device or element referred to must have a specific orientation, and be constructed and operated in the specific orientation, and therefore said terms cannot be understood as limiting the present disclosure.

In addition, the terms "first" and "second" are only used for descriptive purposes, and cannot be understood as indicating or implying relative importance or implicitly indicating the number of indicated technical features. Thus, the features defined by "first" and "second" may explicitly or implicitly include one or more of the features. In the illustration of the present disclosure, the meaning of "a plurality of" is two or two and more, unless explicitly and specifically defined otherwise.

In the present disclosure, unless explicitly specified or limited otherwise, a first feature being "above" or "below" a second feature may include the first and second features being in direct contact, and may also include the first and second features not being in direct contact but being in contact via an another feature therebetween. Furthermore, a first feature being "over", "above", or "on" a second feature may include the first feature being directly above or obliquely above the second feature, or merely means that the first feature having a horizontal height higher than that of the second feature. The first feature being "below", "beneath" or "under" the second feature includes the first feature being directly below or obliquely below the second feature, or merely means that the first feature having a horizontal height lower than that of the second feature.

The following disclosure provides many different embodiments or examples for implementing different structures of the present disclosure. In order to simplify the present disclosure, components and configurations of specific examples are described below. Of course, they are only examples and are not intended to limit the present disclosure. In addition, reference numerals and/or letters may be repeated in different examples in the present disclosure, and such repetition is for the purpose of simplification and clarity, and does not indicate in itself the relationship between the various embodiments and/or configurations discussed. In addition, examples of various specific processes and materials are provided in the present disclosure, but those of ordinary skill in the art can appreciate applications of other processes and/or usage scenarios of other materials.

In the present disclosure, grooves are formed on the polished surface, and at least one pyramid structure with an angle between a side wall and a bottom edge being between 0°-65° is formed in each groove, the presence of the polished regions can improve the brightness of the colored solar cell so as to improve color vividness. Moreover, the arrangements of the grooved regions and the pyramid structures can prevent the reflectivity of the polished surface from being too high so as to improve the power, and then scattering and reflection can be improved, mirror reflection can be reduced, and thus the power of the solar cell is increased while the crystal orientation on the surface of the silicon wafer is disturbed, eliminating the brightness and darkness chromatic aberration caused by the orientation difference of crystal planes on the surface of the silicon wafer.

### Embodiment I

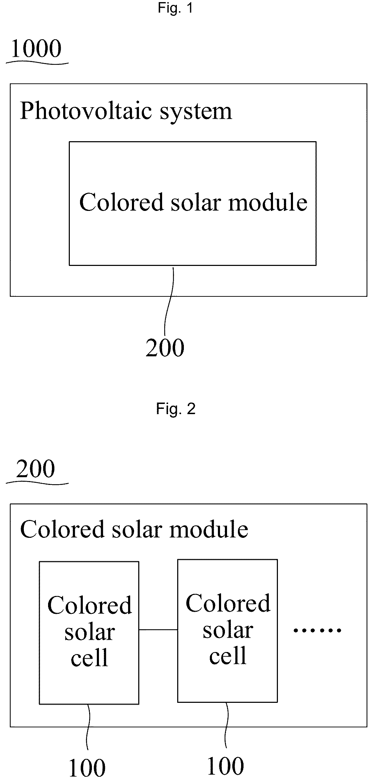

Please refer to Figs. 1 and 2, the photovoltaic system 1000 in the embodiments of the present disclosure may include the colored solar module 200 in the embodiments of the present disclosure, and the colored solar module 200 in the embodiments of the present disclosure may include several colored solar cells 100 in the embodiments of the present disclosure. Specifically, in some embodiments, the colored cell module 200 may include a front plate, a front adhesive film, a cell array, a rear adhesive film, and a back plate (none of which is shown) that are sequentially stacked, and the cell array may include several colored solar cells 100 in the embodiments of the present disclosure.

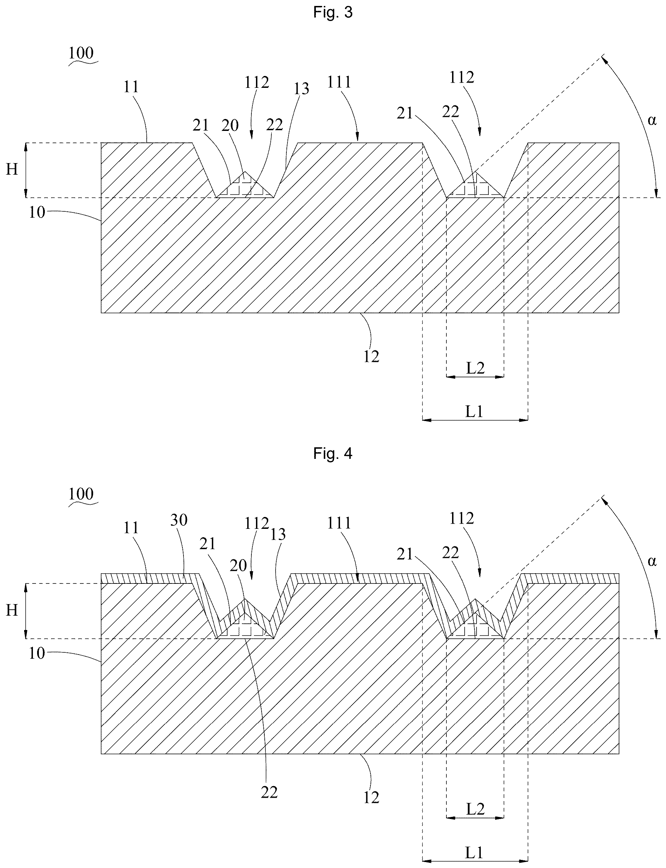

Please refer to Figs. 3 and 4, the colored solar cell 100 in the embodiments of the present disclosure may include a silicon wafer 10, which 10 has a polished surface, and the polished surface may include at least one of a front surface 11 and a back surface 12 of the silicon wafer 10, that is, the front surface 11 or the back surface 12 of the silicon wafer 10 is a polished surface, or both the front surface 11 and the back surface 12 are polished surfaces. Several grooves 13 are formed in a partial region of the polished surface so as to divide the polished surface into polished regions 111 and grooved regions 112, the grooves 13 correspond to the grooved regions 112, at least one pyramid structure 20 is formed in each groove 13, and an angle α (i.e. an angle between the side wall 21 and the polished surface) between the side wall 21 of the pyramid structure 20 and the bottom edge 22 of the pyramid structure 20 is 0°-65°.

In the colored solar cell 100, the colored solar module 200 and the photovoltaic system 1000 according to the embodiments of the present disclosure, the silicon wafer 10 has a polished surface which includes at least one of a front surface 11 and a back surface 12 of the silicon wafer 10, and several grooves 13 are formed in a partial region of the polished surface so as to divide the polished surface into polished regions 111 and grooved regions 112, the grooves 13 correspond to the grooved regions 112, at least one pyramid structure 20 is formed in each groove 13, and an angle α between a side wall 21 of the pyramid structure 20 and a bottom edge 22 of the pyramid structure 20 is 0°-65°. In this manner, grooves 13 are formed on the polished surface and at least one pyramid structure 20 with an angle α between a side wall 21 and a bottom edge 22 being between 0°-65° is formed in each groove 13, the presence of the polished regions 111 can improve the brightness of the colored solar cell 100 so as to improve the color vividness. Moreover, the arrangements of the grooved regions 112 and the pyramid structures 20 can prevent the reflectivity of the polished surface from being too high so as to improve the power, and then scattering and reflection can be improved, mirror reflection can be reduced, and thus the power of the solar cell is increased while the crystal orientation on the surface of the silicon wafer 10 is disturbed, eliminating the brightness and darkness chromatic aberration caused by the orientation difference of crystal planes on the surface of the silicon wafer 10.

Specifically, referring to Fig. 4, in the embodiments of the present disclosure, in order to color the solar cell, a dielectric film layer 30 may be stacked on the silicon wafer 10. The dielectric film layer 30 may be stacked on the polished surface and completely cover the polished regions 111 and the grooved regions 112. The color of the colored solar cell 100 adapts to the thickness and refractive index of the dielectric film layer 30, that is, the color of the colored solar cell 100 may be determined by the thickness and refractive index parameters of the dielectric film layer 30.

In the embodiments of the present disclosure, the front surface 11 and the back surface 12 of the silicon wafer 10 may be disposed in parallel. That is to say, in some embodiments, the polished surface may be the front surface 11 of the silicon wafer 10, the grooves 13 may be formed on the front surface 11, the pyramid structure 20 is formed in the groove 13 of the front surface 11, and the dielectric film layer 30 may cover the front surface 11. In this case, the solar cell is a colored solar cell 100 with the front surface being color (as shown in Fig. 4).

In other embodiments, the polished surface may also be a back surface 12 of the silicon wafer 10, the grooves 13 may also be formed on the back surface 12, the pyramid structure 20 is formed in the groove 13 of the back surface 12, and the dielectric film layer 30 covers the back surface 12. In this case, the solar cell is a colored solar cell 100 with the back surface being color; in this case, the back plate may be a light-transmitting back plate.

In addition, in other embodiments, the polished surface may also include both a front surface 11 and a back surface 12, grooves 13 may be formed on both the front surface 11 and the back surface 12, at least one pyramid structure 20 may be disposed in each of the grooves 13 on both the front surface 11 and the back surface 12, and the front surface 11 and the back surface 12 may be covered with a dielectric film layer 30 in a stacked manner. In this case, the colored solar cell 100 is a double-sided colored solar cell. In the embodiments of the present disclosure, the polished surface may be the front surface 11 of the silicon wafer 10, and in the illustrated embodiment, only the embodiment that the polished surface is the front surface 11, the grooves 13 are formed only on the front surface 11 and the pyramid structure 20 is formed in the groove 13 is shown, but this should not be construed as a limitation to the present disclosure.

In the embodiments of the present disclosure, "pyramid structure 20" may be understood as a cone structure of which the bottom surface is a quadrangle (for example, a square), and may be a cone structure with a tip at the top, and may also be a cone structure with a smooth circle at the top, which is not specifically limited herein. The pyramid structure 20 can be formed by means of alkali texturing, etc., and the groove 13 and the pyramid structure 20 can be formed directly and synchronously by means of an alkaline solution or an acidic solution, that is, the pyramid structure 20 may be directly formed in the process of forming the groove 13.

In the embodiments of the present disclosure, the type of the colored solar cell 100 may be a back-contact solar cell, a PERC solar cell, a topcon solar cell, etc., which is not specifically limited herein. When the colored solar cell 100 is a back-contact solar cell, the front surface 11 (the light-receiving surface of the back-contact solar cell) of the silicon wafer 10 may be provided as the polished surface, several grooves 13 are formed on the front surface 11 and at least one pyramid structure 20 is formed in each groove 13, and the dielectric film layer 30 is also stacked on and cover the front surface 11 of the silicon wafer 10. When the colored solar cell 100 is a PERC solar cell or a topcon solar cell, the front surface 11 of the silicon wafer 10 may be provided as the polished surface to form a single-sided colored cell; alternatively, both the front surface 11 and the back surface 12 of the silicon wafer 10 may be provided as the polished surfaces to form a double-sided colored cell, which is not specifically limited herein.

It should be noted that, in the present disclosure, "the color of the colored solar cell 100 adapts to the thickness and the refractive index of the dielectric film layer 30" may be understood as that the color of the colored solar cell 100 may be determined by the thickness and the refractive index of the dielectric film layer 30, and different thickness ranges and refractive index ranges correspond to different colors and levels of brightness. In addition, the dielectric film layer 30 has a passivation function, that is, the dielectric film layer 30 may also have a passivation function while changing the color of the colored solar cell 100, thereby improving the conversion efficiency of the colored solar cell 100.

In some embodiments, the dielectric film layer 30 may be a silicon nitride film layer, and the colored solar cell 100 may have different colors by setting the thickness and the refractive index of the silicon nitride film layer to be different ranges, so as to satisfy different scenario requirements.

In some embodiments, the dielectric film layer 30 is a composite film, for example, the composite film may include a first film layer and a second film layer. The second film layer and the first film layer are sequentially stacked from inside to outside, and the refractive index of the first film layer is smaller than that of the second film layer. In this manner, the dielectric film layer 30 is provided as a composite film, and the arrangement that the refractive indexes of the first film layer and the second film layer are set to be from low to high can effectively improve the overall reflectivity of the colored solar cell 100 and the colored cell module 200, so as to make the color brighter.

In the embodiments of the present disclosure, the photovoltaic system 1000 can be applied to photovoltaic power stations, such as ground power stations, roof power stations, and water surface power stations, and can also be applied to devices or apparatuses, such as user's solar power sources, solar street lamps, solar vehicles, and solar buildings, that use solar energy to generate electricity. Certainly, it should be understood that application scenarios of the photovoltaic system 1000 are not limited thereto, that is, the photovoltaic system 1000 may be applied in all fields that need to use solar energy to generate electricity. Taking a photovoltaic power generation system grid as an example, the photovoltaic system 1000 may include photovoltaic arrays, a combiner box, and an inverter. Each photovoltaic array may be an array combination of a plurality of colored cell modules 200, for example, the plurality of colored cell modules 200 may form a plurality of photovoltaic arrays which are connected to the combiner box, and the combiner box may combine current generated by the photovoltaic arrays, and the combined current flows through the inverter and converted into alternating current required by the utility grid, and then is connected to the utility grid to implement solar power supply.

The plurality of colored solar cells 100 in the cell array may be connected together in series, so as to form several cell strings. The cell strings may be connected in series, parallel, or a combination of series and parallel to form the cell array, so as to achieve current combination and output. For example, connection of the cell strings may be implemented by disposing solder strips (bus bars and interconnection bars), a conductive backplane, etc.

It should be understood that, in the embodiments of the present disclosure, the front plate can be photovoltaic glass, and the photovoltaic glass can be ultra-clear glass, which has high light transmittance and transparency, and has excellent physical, mechanical and optical properties. For example, the light transmittance of the ultra-clear glass can be up to 92% or more, and can protect the colored solar cell 100 without affecting the efficiency of the colored solar cell 100 as far as possible.

The back plate can protect and support the colored solar cell 100, and has reliable insulation, water resistance and aging resistance performances. There may be multiple choices for the back plate, usually be tempered glass, organic glass, an aluminum alloy TPT composite adhesive film, etc., which can be specifically set according to specific situations, which is not limited herein. The front adhesive film may be filled between the front surface of the colored solar cell 100 and the photovoltaic glass, the rear adhesive film may be filled between the back surface of the colored solar cell 100 and the back plate, and the front adhesive film and the rear adhesive film may seal and insulate as well as waterproof and moisture-proof for the colored solar cell 100. Both the front adhesive film and the rear adhesive film may be transparent colloids with good light transmission performance and ageing resistance performance, such as EVA adhesive films or POE adhesive films, which can be selected according to actual situations, and are not limited herein.

In some embodiments, the colored cell module 200 can further include a metal frame, and the entirety composed of the front plate, the front adhesive film, the cell array, the rear adhesive film and the back plate may be disposed on the metal frame. The metal frame serves as the main external support structure for the entire colored solar module 200, and can stably support and mount the colored solar module 200, for example, the colored solar module 200 may be mounted by the metal frame at a location where it is desired to be mounted.

### Embodiment II

Please refer to Figs. 3 and 4, in some embodiments, the angle α between the side wall 21 of the pyramid structure 20 and the bottom edge 22 of the pyramid structure 20 may be 45°-60°, that is, the value range of the angle α in the figure is 45°≤α≤60°.

In this manner, the angle α between the side wall 21 of the pyramid structure 20 and the bottom edge 22 of the pyramid structure 20 is set within the range above, such that it is possible to improve the color vividness without affecting the efficiency due to too high reflectivity of the surface of the silicon wafer 10, and it can also prevent the reflectivity of the surface of the silicon wafer 10 from being too low, which would otherwise result in an insignificant enhancement of color vividness. That is to say, setting the angle α between the side wall 21 of the pyramid structure 20 and the bottom edge 22 of the pyramid structure 20 to be within a small angle range of 45°-60° can prevent the angle α between the side wall 21 of the pyramid structure 20 and the bottom edge 22 of the pyramid structure 20 from being too small, which would result in an excessive reduction in reflectivity, and can also prevent the angle α between the side wall 21 of the pyramid structure 20 and the bottom edge 22 of the pyramid structure 20 from being too large, which would result in an insufficient reduction in reflectivity.

Specifically, in such embodiments, the angle α between the side wall 21 of the pyramid structure 20 and the bottom edge 22 of the pyramid structure 20 is, for example, 45°, 46°, 47°, 48°, 49°, 50°, 51°, 52°, 53°, 54°, 55°, 56°, 57°, 58°, 59°, 60°, or any value between 45°-60°, which is not specifically limited herein.

### Embodiment III

Referring to Figs. 3 and 4, in some embodiments, the depth H of the groove 13 may be greater than or equal to the height of the pyramid structure 20, which is not specifically limited herein.

In this manner, setting the depth H of the groove 13 to be greater than or equal to the height of the pyramid structure 20 can avoid that the tip of the pyramid structure 20 extends out of the groove 13, which facilitates subsequent thin film deposition and reduces defects generated during thin film deposition.

### Embodiment IV

In some embodiments, the depth H of the groove 13 may be 0.2 um-10 um. In this manner, it can prevent the depth of the groove 13 from being too shallow to form the pyramid structure 20, and can also prevent the depth of the groove 13 from being too deep, which would significantly reduce the strength of the silicon wafer 10 and lead to subsequent issues such as latent cracks and wafer breakage.

Specifically, the size of the depth H of the groove 13 may be, for example, 0.2 um, 0.3 um, 0.4 um, 0.5 um, 0.6 um, 0.7 um, 0.8 um, 0.9 um, 1 um, 2 um, 3 um, 4 um, 5 um, 6 um, 7 um, 8 um, 9 um, 10 um or any value between 0.2 um-10 um, which is not specifically limited herein.

Referring to Figs. 3 and 4, in some embodiments, the width L1 of the groove 13 may be 0.2 um-10 um. In this manner, it can prevent the width of the groove 13 from being too wide, which would cause the proportion of the groove 13 on the polished surface to be too large, leading to a significant reduction in the surface reflectivity of the silicon wafer 10 and failure to achieve the expected effect of enhancing color vividness.

Specifically, the size of the width L1 of the groove 13 may be, for example, 0.2 um, 0.3 um, 0.4 um, 0.5 um, 0.6 um, 0.7 um, 0.8 um, 0.9 um, 1 um, 2 um, 3 um, 4 um, 5 um, 6 um, 7 um, 8 um, 9 um, 10 um or any value between 0.2 um-10 um, which is not specifically limited herein.

In some embodiments, the size of the width L2 of the groove 13 may be greater than or equal to that of the bottom edge 22 of the pyramid structure 20.

### Embodiment V

In some embodiments, the size L2 of the bottom edge 22 of the pyramid structure 20 may be 0.2 um-10 um.

In this manner, setting the size of the bottom edge of the pyramid structure 20 within this reasonable range can effectively reduce the reflectivity of the whole polished surface so as to improve color vividness while ensuring its function.

Specifically, in such embodiments, the size L2 of the bottom edge of the pyramid structure 20 may be, for example, 0.2 um, 0.3 um, 0.4 um, 0.5 um, 0.6 um, 0.7 um, 0.8 um, 1 um, 2 um, 3 um, 4 um, 5 um, 6 um, 7 um, 8 um, 9 um, 10 um or any value between 0.5 um-10 um, which is not specifically limited herein.

### Embodiment VI

In some embodiments, a ratio of the area of the polished regions 111 to that of the polished surface may be 15%-85%.

In this manner, setting the area proportion of the polished regions 111 within the reasonable range above can prevent the area proportion of the polished region 111 from being too small, which would significantly reduce reflectivity and fail to achieve the effect of enhancing color vividness, and can also prevent the area proportion of the polished region 111 from being too large, which would lead to a significant reduction in power.

Specifically, in such embodiments, the ratio of the area of the polished regions 111 to that of the polished surface may be, for example, 15%, 20%, 25%, 30%, 35%, 40%, 45%, 50%, 55%, 60%, 65%, 70%, 75%, 80%, 85%, or any value between 15%-85 %, which is not specifically limited herein.

### Embodiment VII

In some embodiments, a ratio of the area of the grooved regions 112 to that of the polished surface can be 15%-85%.

In this manner, setting the area proportion of the grooved region 112 within the reasonable range above can prevent the area proportion of the grooved region 112 from being too small, which would result in limited reflectivity reduction and lower power, and can also prevent the area proportion of the grooved region 112 from being too large, which would cause an excessive reduction in reflectivity, failing to achieve the expected effect of enhancing color vividness.

Specifically, in such embodiments, the ratio of the area of the grooved regions 112 to that of the polished surface may be, for example, 15%, 20%, 25%, 30%, 35%, 40%, 45%, 50%, 55%, 60%, 65%, 70%, 75%, 80%, 85%, or any value between 15%-85 %, which is not specifically limited herein.

Further, in the embodiments of the present disclosure, the area of the grooved regions 112 may be set to be smaller than that of the polished regions 111. In this manner, setting only a small portion of the polished surface as the grooved regions 112 with the pyramid structures 20 can reduce reflectivity to increase power and disrupt the crystal orientation on the surface of the silicon wafer 10, while ensuring that the polished surface maintains high reflectivity to preserve color vividness.

### Embodiment VIII

In some embodiments, the several grooves 13 may be randomly distributed, and specifically, in such embodiments, the grooves 13 may be formed by alkaline etching or acid etching.

Certainly, in some embodiments, the several grooves 13 may also be distributed in an array, and in such embodiments, the grooves 13 may be formed by etching with a dot matrix laser.

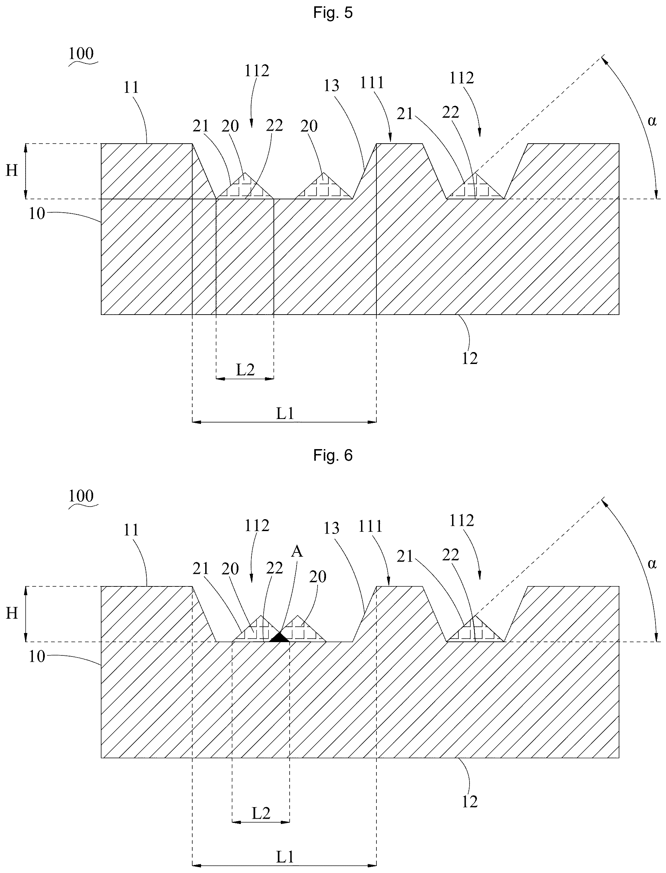

In addition, referring to Fig. 5, in some embodiments, a plurality of pyramid structures 20 may be correspondingly disposed in a single groove 13, and the plurality of pyramid structures 20 may be independent of each other.

Certainly, it should be understood that, referring to Fig. 6, in some embodiments, at least some pyramid structures 20 within a single groove 13 may also overlap with each other (an intersection region A is as shown in Fig. 6).

In the present disclosure, it is easily understood that a single groove 13 may correspond to a single pyramid structure 20, or a single groove 13 may correspond to two or more pyramid structures 20. The pyramid structures 20 in the single groove 13 may be independent of each other, or at least some second pyramid structures 20 may overlap, for example, every two adjacent pyramid structures 20 overlap, some pyramid structures 20 overlap, or some other pyramid structures 20 are independent of each other, which is not limited herein.

In addition, in the present disclosure, a single pyramid structure 20 may be disposed in all the grooves 13, or a plurality of pyramid structures 20 may be disposed in all the grooves 13, or a single pyramid structure 20 may be disposed in some grooves 13, while a plurality of pyramid structures 20 are disposed in other grooves 13, which is not limited herein.

### Embodiment IX

Referring to Figs. 3-4, in some embodiments, the pyramid structure 20 has a sharp tip at the top, that is, the pyramid structure 20 has a pointed apex.

In this manner, the process for forming the pyramid structure 20 with a sharp tip at the top has relatively low difficulty, facilitating manufacture.

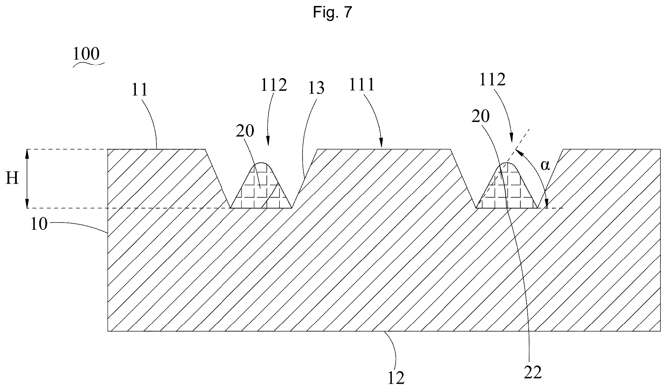

Certainly, referring to Fig. 7, in other embodiments, the top of the pyramid structure 20 may also be arc-shaped, that is, the pyramid structure 20 has a smooth pyramid pointed apex, which can facilitate subsequent film deposition and reduce defects generated during film deposition.

It should be noted that, as shown in Fig. 7, in such embodiments, the angle α between the side wall 21 and the bottom edge 22 of the pyramid structure 20 refers to an angle between a connection line between an apex of the pyramid structure 20 and the endpoint of the bottom edge 22 and the bottom edge 22 of the pyramid structure 20.

Specifically, in such embodiments, during texturing, an alkaline solution may be used to perform texturing on the surface of the silicon wafer 10 so as to form a pyramid structure 20 having a sharp tip, and then an acidic or alkaline solution is used to perform a rounding treatment on the pointed apex of the pyramid structure 20.

In the description of the present disclosure, the descriptions of the reference terms such as "some embodiments", "illustrative embodiments", "examples", "specific examples", or "some examples" means that the specific features, structures, materials or characteristics described in combination with the embodiments or examples are included in at least one embodiment or example of the present disclosure. In this description, the exemplary expressions of the above terms do not necessarily refer to the same embodiment or example. Furthermore, the described specific features, structures, materials, or characteristics may be combined in any suitable manner in one or more embodiments or examples.

Moreover, the described content merely relates to preferred embodiments of the present disclosure, and is not intended to limit the present disclosure. Any modifications, equivalent replacements, improvements, etc. made within the spirit and principle of the present disclosure shall all fall within the scope of protection of the present disclosure.

## Claims

1. A colored solar cell, comprising a silicon wafer having a polished surface which comprises at least one of a front surface and a back surface of the silicon wafer, wherein several grooves are formed on a partial region of the polished surface so as to divide the polished surface into polished regions and grooved regions, the grooves correspond to the grooved regions, at least one pyramid structure is formed in each groove, and an angle between a side wall of the pyramid structure and a bottom edge of the pyramid structure is 0°-65°.

2. The colored solar cell according to claim 1, wherein the angle between the side wall of the pyramid structure and the bottom edge of the pyramid structure is 45°-60°.

3. The colored solar cell according to claim 1, wherein a depth of the groove is greater than or equal to a height of the pyramid structure.

4. The colored solar cell according to claim 1, wherein a depth of the groove is 0.2 um-10 um.

5. The colored solar cell according to claim 1, wherein a width of the groove is 0.2 um-10 um.

6. The colored solar cell according to claim 1, wherein a ratio of an area of the polished regions to an area of the polished surface is 15%-85%.

7. The colored solar cell according to claim 1, wherein a ratio of an area of the grooved regions to an area of the polished surface is 15%-85%.

8. The colored solar cell according to claim 1, wherein an area of the grooved region is smaller than an area of the polished region.

9. The colored solar cell according to claim 1, wherein a width of the groove is greater than or equal to a size of the bottom edge of the pyramid structure.

10. The colored solar cell according to claim 1, wherein a size of the bottom edge of the pyramid structure is 0.2 um-10 um.

11. The colored solar cell according to claim 1, wherein the several grooves are distributed randomly or in an array.

12. The colored solar cell according to claim 1, wherein a plurality of pyramid structures are correspondingly disposed in a single groove, and the plurality of pyramid structures are independent of each other or at least some of the plurality of pyramid structures overlap with each other.

13. The colored solar cell according to claim 1, wherein the pyramid structure has a sharp tip at a top; or
the pyramid structure has an arc-shaped top, and the angle between the side wall of the pyramid structure and the bottom edge of the pyramid structure is an angle between a connection line between an apex of the top of the pyramid structure and an endpoint of the bottom edge of the pyramid structure and the bottom edge of the pyramid structure.

14. A colored cell module, comprising several colored solar cells according to any one of claims 1-13.

15. A photovoltaic system, comprising the colored cell module according to claim 14.
